Europäisches Patentamt

European Patent Office

Office européen des brevets

(11) Publication number: **0 315 421 B1**

(12) **EUROPEAN PATENT SPECIFICATION**

(45) Date of publication of patent specification: **18.05.94**    (51) Int. Cl.5: **H01L 21/60**, H01L 21/90, H01L 21/76

(21) Application number: **88310284.0**

(22) Date of filing: **02.11.88**

(54) Semiconductor integrated circuit device having at least two contact holes.

(30) Priority: **05.11.87 JP 278285/87**

(43) Date of publication of application:
**10.05.89 Bulletin 89/19**

(45) Publication of the grant of the patent:
**18.05.94 Bulletin 94/20**

(84) Designated Contracting States:
**FR**

(56) References cited:
**EP-A- 0 242 893**

**IBM TECHNICAL DISCLOSURE BULLETIN, vol. 24, no. 7B, December 1981, pages 3806-3807, New York, US; D.B. REDDING: "Borderless diffusion contact"**

**IDEM**

**IBM TECHNICAL DISCLOSURE BULLETIN, vol. 27, no. 3, August 1984, pages 1809-1812, New York, US; C.G. JAMBOTKAR: "Emitter butting against recessed oxide isolation in bipolar integrated circuits"**

**PATENT ABSTRACTS OF JAPAN, vol. 11, no.**

**51 (E-480)[2498], 17th February 1987; & JP-A-61 214 553**

(73) Proprietor: **FUJITSU LIMITED**
**1015, Kamikodanaka**
**Nakahara-ku**
**Kawasaki-shi Kanagawa 211(JP)**

(72) Inventor: **Ema, Taigi**
**1453-101, Suenaga**
**Takatsu-ku**
**Kawasaki-shi Kanagawa, 213(JP)**

(74) Representative: **Billington, Lawrence Emlyn et al**
**HASELTINE LAKE & CO**
**Hazlitt House**
**28 Southampton Buildings**
**Chancery Lane**
**London WC2A 1AT (GB)**

## Description

The present invention generally relates to a semiconductor integrated circuit device, and particularly to an improvement of a contact hole structure used for making an electric contact between a silicon substrate and a conductive film such as an electrode and a wiring (interconnection) line. More particularly, the present invention relates to a semiconductor integrated circuit device having a contact hole structure which can provide a pitch between adjacent electrodes or wiring lines which is narrower than a minimum pitch obtained by photolithography technology.

Generally, an electrode or a wiring line of a semiconductor integrated circuit device is formed by forming a contact hole in an insulation film formed on a surface of a substrate and then forming an electrode or a wiring line which is provided so as to cover the contact hole and which is a little larger (wider) than the contact hole. The use of the larger electrode or wiring line is intended to cope with the occurrence of a positional error or alignment error which may occur at the time of forming an electrode or wiring line. That is, the electrode or wiring line is designed to have an alignment tolerance. The alignment tolerance functions to prevent a surface area of the substrate from appearing even when an alignment error occurs. If a surface area appears due to the alignment error, it is exposed to etching, and therefore a recess portion is formed in the substrate.

A distance between the centers of neighbouring electrodes (hereinafter referred to as an electrode pitch) which are in contact with the substrate through respective contact holes, is necessarily defined by parameters such as a size of a contact hole, an alignment tolerance of an electrode, and a distance between opposed edges of the neighboring electrodes. Generally, the above parameters depend on the accuracy of photolithography technology. As a result, the electrode pitch depends on the accuracy of photolithography technology. This means that there is a limit on the electrode pitch which can be obtained by photolithography technology. The above holds true for a wiring line which is in contact with a substrate through a contact hole.

In order to enhance the integration density of a semiconductor integrated circuit device, it is essential to reduce the electrode pitch. However, with current production processes which employ photolithography technology, a reduced electrode pitch can be obtained no longer. For this reason, a means which enables the electrode pitch to be reduced, is desired.

It is therefore desirable to provide a semiconductor integrated circuit device in which the aforementioned disadvantages of the conventional art are eliminated.

It is also desirable to provide a semiconductor integrated circuit device in which electrodes or wiring lines are arranged with a pitch smaller than a minimum pitch available by the conventional photolithography technology.

EP-A-0 242 893 discloses a semiconductor device having the features of the preamble of accompanying claim 1. The contact holes in this device are partly located on the field insulation film so that one edge of the contact hole is defined by the edge of the field insulation film, an opposite edge being defined by the other insulating film.

IBM Technical Disclosure Bulletin, Vol. 24, No. 7B, pages 3806-7, discloses a borderless diffusion contact in which one edge of a contact hole is bounded by a field oxide layer and an opposite edge is bounded by a thick doped oxide layer.

According to the present invention, there is provided a semiconductor integrated circuit device comprising:-

a semiconductor substrate;

a field insulation film formed on a surface of the semiconductor substrate and having edges in the form of bird's beak portions;

an insulation film having at least two contact holes formed on the field insulation film, edges of the contact holes being defined by edges of the field insulation film or insulation film; and

electrodes covering the contact holes so as to be in contact with the surface of the substrate;

characterised in that both opposite edges of each contact hole which extend in a first direction are defined by said bird's beak portions, and both opposite edges of each contact hole which extend in a second direction are defined by edges of the insulation film;

whereby the electrode pitch between adjacent electrodes in the second direction is substantially given by the formula 2(F + M-B) wherein F is a minimum pattern width, M is an alignment tolerance, and B is the length of the bird's beak in the second direction.

Reference is made, by way of example, to the accompanying drawings, in which:-

Fig. 1A is a plan view of an essential part of a preferred embodiment of the present invention;

Figs. 1B and 1C are cross-sectional views taken along lines X-X and Y-Y shown in Fig. 1A, respectively;

Figs. 2A and 2B are cross-sectional views along the line Y-Y which illustrate differences between the prior art and the embodiment of the invention; and

Figs. 3 through 9, and Figs. 10 through 15 are cross-sectional views along the lines X-X and Y-Y observed at respective steps in a manufacturing process, respectively.

In order to meet the requirement for reducing the electrode pitch or wiring pitch, the inventor conceived a contact structure in which an edge of a field insulation film itself is used as an edge of a contact hole extending in a direction perpendicular to a direction in which it is necessary to establish a very high alignment or positioning accuracy.

Generally, in a semiconductor integrated circuit device, a very high alignment accuracy is required in either one of mutually orthogonal directions, which are hereinafter referred to as X and Y directions. For example, when a very high alignment accuracy is required for reducing size of elements in the Y direction, a relatively large tolerance of alignment accuracy is generally allowed in the X direction. Therefore, an edge of an electrode contact hole which extends in the Y direction may be formed by using a resist mask used in the conventional photolithography technology.

It is well known that a field insulation film such as a silicon dioxide ($SiO_2$) film is formed by coating a part of a surface of a silicon substrate with an oxidation-resistant mask such as a silicon nitride ($Si_3N_4$) mask, and then subjecting the silicon substrate to selective thermal oxidation. It is also known that a bird's beak resulting from oxidation in a lateral direction is produced at an edge of the field insulation film produced in the aforementioned process. By removing the silicon nitride film used as the oxidation-resistant mask, a portion of the silicon surface is exposed which has a size smaller than a designed size.

The present invention utilizes the bird's beak to define an edge of a contact hole which extends in a direction perpendicular to a direction in which a very high alignment accuracy is required. With this proposal, it becomes possible to obtain a reduced electrode pitch or wiring line pitch, which cannot be obtained by the conventional photolithography technology.

It is noted that the Japanese Patent Publication No.61-55258 suggests a variation in contact size due to lateral oxidation (bird's beak) which occurs in a case when a selectively oxidized insulation film is formed by local oxidation. The above publication teaches that change in contact size due to lateral oxidation causes an increase of a leakage current which passes through a MOS device. On the other hand, the present invention intends to positively utilize the bird's beak in order to reduce the electrode pitch.

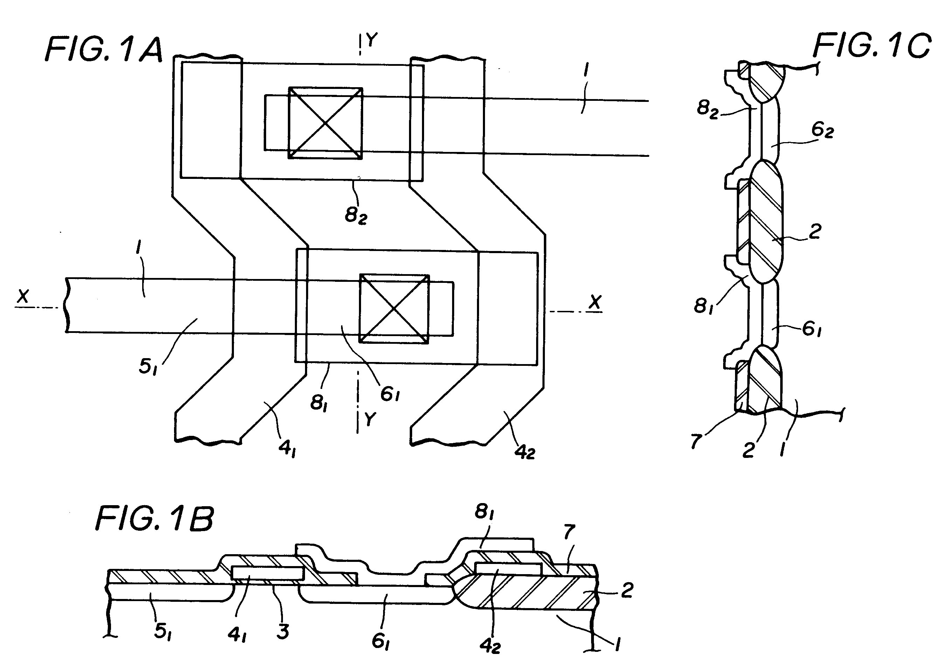

FIGS.1A through 1C are views of a portion of a semiconductor integrated circuit device for explaining essential features of an embodiment of the invention. FIG.1A is a plan view of a portion of the device of the invention, FIG.1B is a cross sectional view taken along a line X-X shown in FIG.1A, and FIG.1C is a plan view taken along a line Y-Y. The illustrated semiconductor integrated circuit device is a stacked capacitor type dynamic random access memory device (hereinafter simply referred to as a DRAM device). The DRAM device comprises a plurality of memory cells, each of which consists of a memory capacitor and a transfer gate transistor.

Referring to FIGS.1A through 1C, a field insulation film 2 made of silicon dioxide ($SiO_2$) is partially formed on a surface of a p-type silicon substrate 1. A gate insulation film 3 made of silicon dioxide ($SiO_2$) is formed on the surface of the substrate 1. Gate electrodes $4_1$ and $4_2$ made of polysilicon are formed on the gate insulation film 3 and the field insulation film 2, respectively. The gate electrodes $4_1$ and $4_2$ are used as word lines of the DRAM device. An $n^+$-type source region $5_1$, which is a bit line contact region, is formed in the substrate 1. An $n^+$-type drain region $6_1$ and $6_2$, which are capacitor contact regions, are formed in the substrate 1. An interlayer insulation film 7 is formed as shown by chemical vapor deposition (CVD). Storage electrodes $8_1$ and $8_2$, each of which is one of paired electrodes of a memory capacitor, are formed as shown in FIGS.1B and 1C. It is noted that for the sake of simplicity, some conventional elements of the DRAM are omitted. For example, there are omitted an opposed electrode of an opposed electrode, called a cell plate, a bit line contact window formed on the source region of a transfer gate transistor, a wiring line used for forming a low resistance bit line and a low resistance word line and some insulation films.

As can be seen particularly in FIG.1B, with respect to the storage electrodes $8_1$ and $8_2$, edges of the contact holes extending in the Y direction are formed by patterned edges of the interlayer insulating film 7. On the other hand, it can be seen from FIG.1C that edges of the contact holes extending in the X direction are defined by edges of the field insulation films 2 which have bird's beaks. A side wall of the contact hole is formed by a vertical end surface of the interlayer insulating film 7. The electrode $8_1$ is deposited on the surface of the drain region $6_1$, the edges (bird' beaks) of the field insulation film 2, and end portions of the interlayer insulation film 7.

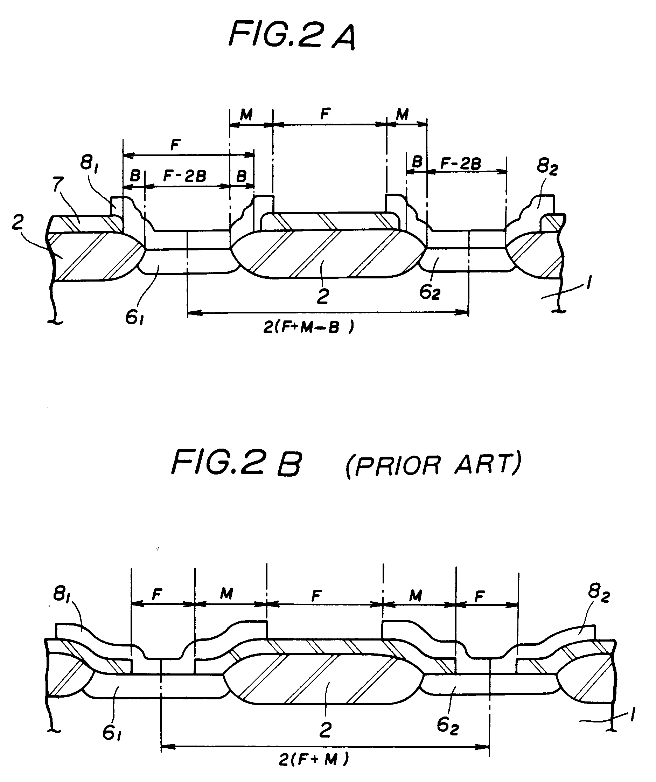

A description is given of electrode pitches obtained by photolithography technology and the present embodiment with reference to Figs. 2A and 2B. The structure of FIG.2A corresponds to that of FIG.1C, and FIG.2B illustrates a corresponding structure of a conventional semiconductor integrated circuit device in the Y direction. In FIGS.2A and 2B, F is a minimum pattern width which is determined depending on the accuracy of photolithography technology, M is an alignment tolerance, and B is a length of a bird's beak in the Y direction. In FIG.2B, elements identical to or similar to those in the previous figures are indicated by the same reference numerals.

It can be seen from FIG.2A that the electrode pitch in the present embodiment is represented as $2(F + M - B)$, and the electrode pitch of the conventional device is represented as $2(F + M)$. For example, when $F = 1.0 \mu m$, $M = 0.3 \mu m$, and $B = 0.3 \mu m$, the electrode pitch of the present embodiment is equal to 2.0 $\mu m$, and on the other hand, the electrode pitch of the conventional device is equal to 2.6 $\mu m$. That is, in the above example, it is possible to obtain a 23% reduction of the electrode pitch. As a result, in the Y direction in which the electrode pitch is desired to be as small as possible, there is obtained the electrode pitch having a size smaller than the minimum size available by the conventional photolithography technology. Hence a reduced element of the device can be obtained, and thereby the integration density can be improved. As will be described later, the contact hole of the present invention can be formed by using a slightly modified mask for forming the contact hole. This means that the contact hole of the present invention can be provided by the currently available production process. Further, since edges of the contact hole 7A in the same direction are formed by the same process, there may be no difference in electrical characteristics between elements in the device even when the alignment error occurs.

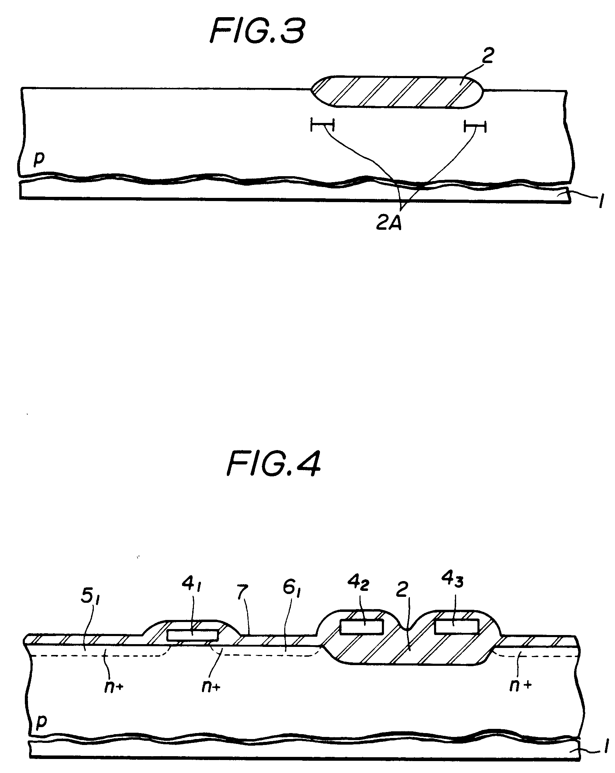

A description is given of a preferred embodiment of the present invention with reference to FIGS.3 through 15, which show respective essential steps of the production process for producing the preferred embodiment of the present invention. FIGS.3 through 9 are cross sectional views taken along the line X-X shown in FIG.1A, and FIGS.10 through 15 are cross sectional views taken along the line Y-Y shown in FIG.1A. In FIGS.2 through 15, those parts which are the same as those in the previous figures, are given the same reference numerals. It is noted that some cross sections shown in these figures do not necessarily correspond to that of FIG.1A, and may be wider than the cross section defined in FIG.1A.

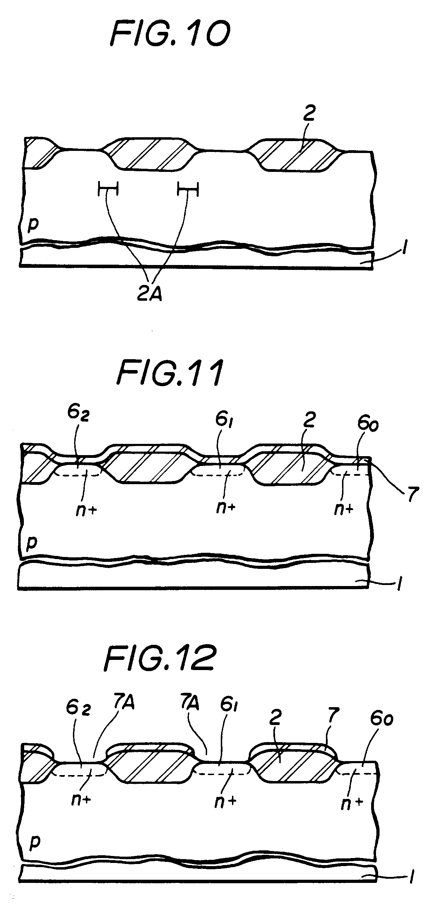

Referring to FIGS. 3 and 10, a photoresist film which covers active regions is formed by a resist process employed in the conventional photolithography technology. Thereafter, boron (B) ions are implanted into the active regions by ion implantation. Thereby an element separation region (not shown) is formed.

The photoresist film is removed, and then the field insulation film 2 is formed by the conventional selective thermal oxidation process in which a silicon nitride ($Si_3N_4$) film or the like is used as a oxidation-resistant mask.

It is well known that an edge of the field insulation film 2 thus formed goes under the oxidation-resistant mask. This edge is the bird's beak. In FIGS.3 and 10, each of the bird's beaks is indicated by an H-shaped symbol indicated by a reference 2A. The size of the bird's beak depends on thickness and width of the oxidation-resistant mask and so on. Generally, the width of the bird's beak edge is approximately 300nm. By removing the oxidation-resistant mask, the bird's beaks 2A of the field insulation film 2 appear.

Referring to FIGS.4 and 11, the gate insulation film such as a silicon dioxide film having a thickness of approximately 20nm, is formed by thermal oxidation. In FIGS.4 and 11, the gate insulation film is illustrated integrally with the interlayer insulation film 7 for the sake of simplicity. Thereafter, a polysilicon film is deposited to a thickness of approximately 200nm by chemical vapor deposition (CVD). Then, gate electrodes $4_1$, $4_2$, $4_3$,... are formed by patterning the polysilicon film by the conventional photolithography technology. The gate electrodes $4_1$, $4_2$, $4_3$,... are word lines. By ion implantation, arsenic (As) ions are implanted into the substrate 1, and thereby $n^+$-type source regions $5_1$, $5_2$,... are formed, and $n^+$-type drain regions $6_1$, $6_2$,... are formed. The source regions $5_1$, $5_2$,... are bit line contact regions, and the drain regions $6_1$, $6_2$,... are contact regions for storage electrodes of memory capacitors. Prior to the aforementioned ion implantation step, a protection film such as a silicon dioxide ($SiO_2$) film may be formed as necessary.

Then the interlayer insulation film 7 such as a silicon dioxide ($SiO_2$) film is deposited to a thickness of approximately 100nm by chemical vapor deposition.

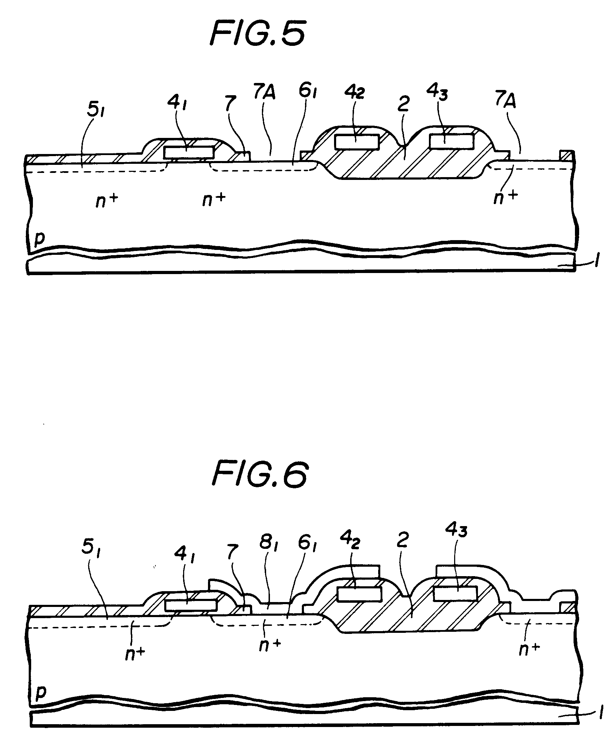

Referring to FIGS.5 and 12, the interlayer insulation film 7 is subjected to anisotropic etching by using the resist process in the conventional photolithography technology and reactive ion etching (RIE) in which an etching gas of $CHF_3 + H_2$ is used. Thereby, a contact hole 7A is formed in the interlayer insulation film 7. In this case, it is essential to use the etching mask having a mask size which makes it possible to obtain an exposed active region surface (drain region surface) having a size identical to a designed size with respect to the X direction, and which enables the edges 2A of the field insulation film 2 (bird's beak portions) to be exposed with respect to the Y direction.

The step of FIGS.5 and 12 is very important, and is clearly distinct from the conventional step. In order to expose the bird's beaks 2A of the field insulation film 2 without the bird's beaks 2A being damaged due to the aforementioned etching process, it is necessary to detect a variation of an emission spectrum of RIE plasma which occurs when the substrate 1 becomes exposed by etching of the interlayer insulation film 7, and to terminate etching when the variation is detected. With this process, it is possible to form the exposed active region surface having a size in the Y direction which cannot be achieved by the conventional photolithography technology. As a result, a reduced electrode pitch and a reduced memory cell can be obtained.

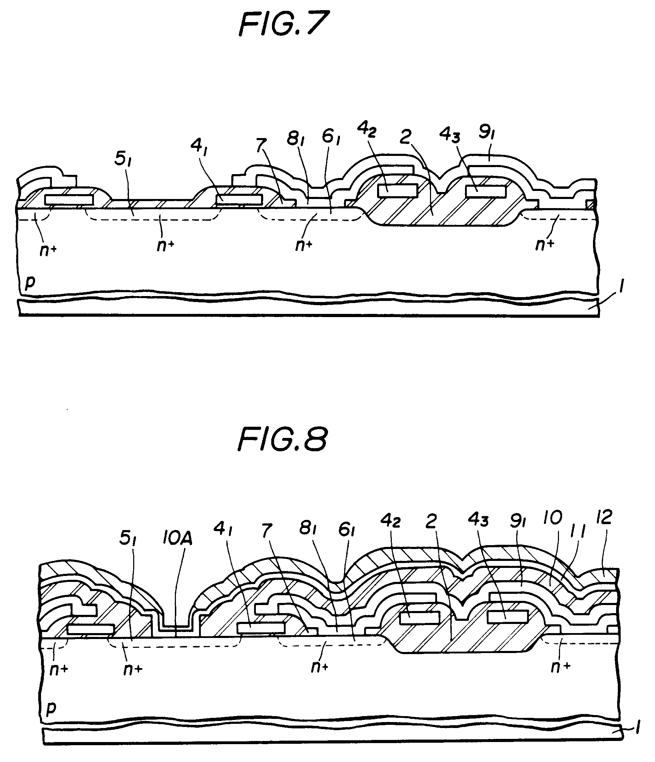

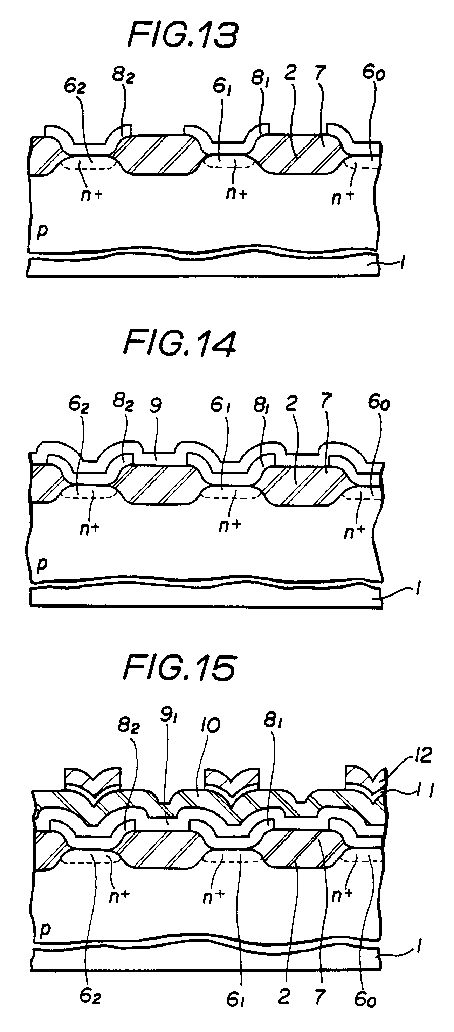

Referring to FIGS.6 and 13, the polysilicon film 8 is deposited to a thickness of approximately 200nm by chemical vapor deposition. Then the polysilicon film 8 is patterned by the conventional photolithography technology, and thereby the storage electrodes $8_1$, $8_2$,... are formed. Each storage electrode is one of the paired electrodes of a memory capacitor. Then, silicon dioxide ($SiO_2$) films are formed so as to cover the respective storage electrodes $8_1$, $8_2$... by thermal oxidation. The silicon dioxide films thus formed function as dielectric films of the respective memory capacitor. Each silicon dioxide film has a thin thickness of approximately 10nm, and therefore is not shown in FIGS.7 and 14.

Thereafter, the polysilicon film 9 is deposited to a thickness of about 200nm by chemical vapor deposition. Then the polysilicon film 9 is subjected to the patterning process which employs the conventional photolithography technology. Thereby, the opposed electrodes $9_1$, $9_2$,..., are formed, each of which is the other electrode of the memory cell and is called a cell plate.

Referring to FIGS.8 and 15, the interlayer insulation film 10 is deposited to a thickness of 250nm, for example, by chemical vapor deposition. Then, the interlayer insulation film 10 is subjected to anisotropic etching by using the resist process of the conventional photolithography technology and reactive ion etching in which an etching gas of $CHF_3$ + $H_2$ is used. By anisotropic etching, a layer portion from the surface of the interlayer insulation film 10 to the substrate 1 is removed, and thereby a contact hole 10A is formed in the interlayer insulation film 10.

In this case, it is necessary to use an etching mask similar to that of the etching mask used in the aforementioned step. That is, the etching mask has a mask size which makes it possible to obtain an exposed active region surface (source region surface) which has a size identical to a designed size with respect to the X direction, and which enables the edges of the field insulation film 2 to be exposed with respect to the Y direction. As in case of the step related to FIGS.5 and 12, in order to expose the edges of the field insulation film 2 without the edges being prevented from being damaged due to etching, it is essential to detect a variation of an emission spectrum of RIE plasma which occurs when the substrate 1 is exposed by etching for the interlayer insulation film 7, and to terminate etching when the variation is detected. With this process, it is possible to form the exposed active region surface having a size which cannot be achieved by the conventional photolithography technology process and which is identical to a designed size. As a result, a reduced electrode pitch and a reduced memory cell can be obtained.

Thereafter, a polysilicon film 11 is deposited to a thickness of approximately 100nm by chemical vapor deposition. Subsequently, a tungsten silicide ($WSi_x$) film 12 having a thickness of approximately 200nm is formed by sputtering. Then the polysilicon film 11 and the tungsten silicide film 12 are patterned by the conventional photolithography technology, and thereby bit lines are formed.

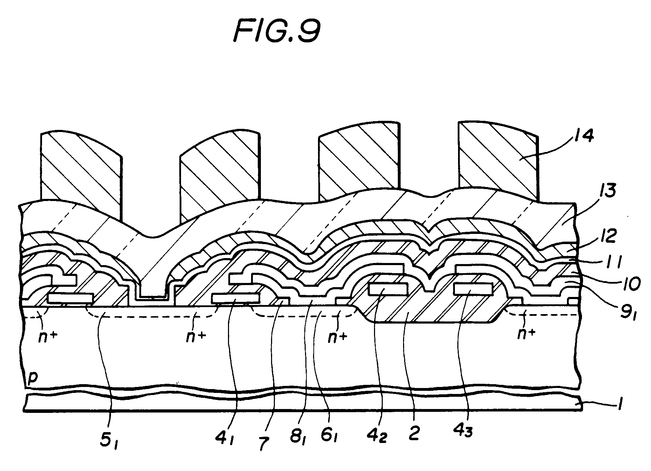

Referring to FIG.9, a passivation film 13 of a phosphosilicate glass (PSG) film is deposited on the entire surface of the tungsten silicide film 12 by chemical vapor deposition. Then gate wiring lines 14 made of aluminum for example, are formed on top of the passivation film 13. The gate wiring lines 14 are used for making up conductivity of the gate electrodes $4_1$, $4_2$ and so on. The passivation film 13 and the gate wiring lines 14 are employed in the conventional DRAM device. Finally a phosphosilicate glass film and a silicon nitride film are grown as a cover film, and then bonding pads are formed on the cover film.

Materials used for forming the aforementioned films are not limited to the aforementioned embodiment. Appropriate materials used in the conventional devices can be employed. Further, thicknesses of the films are not limited to the aforementioned thickness. The present invention is not limited to the aforementioned stacked capacitor type DRAM device, and includes other types of devices.

**Claims**

1. A semiconductor integrated circuit device comprising:-

a semiconductor substrate (1);

a field insulation film (2) formed on a surface of the semiconductor substrate and having edges in the form of bird's beak portions (2A);

an insulation film (7) having at least two four-sided contact holes (7A) formed on the field insulation film, edges of the contact holes being defined by edges of the field insulation film (2) or insulation film (7); and

electrodes ($8_1$, $8_2$, 11) covering the contact holes so as to be in contact with the surface of the substrate;

characterised in that both opposite edges of each contact hole which extend in a first direction (X) are defined by said bird's beak portions (2A), and both opposite edges of each contact hole which extend in a second direction (Y) are defined by edges of the insulation film (7);

whereby the electrode pitch between adjacent electrodes in the second direction (Y) is substantially given by the formula 2(F + M-B) wherein F is a minimum pattern width, M is an alignment tolerance, and B is the length of the bird's beak in the second direction (Y).

2. A semiconductor integrated circuit device as claimed in claim 1, wherein the electrodes ($8_1$, $8_2$, 11) extend on the edges of the field insulation film (2).

3. A semiconductor integrated circuit device as claimed in claim 1 or 2, wherein a surface portion of the substrate (1) which is exposed through the contact hole (7A) has a size in the second direction (Y) smaller than a size of the contact hole formed in the insulation film (7).

4. A semiconductor integrated circuit device as claimed in claim 1, 2 or 3, wherein the substrate comprises active regions ($6_1$, $6_2$) which are doped with an impurity, and the electrodes ($8_1$, $8_2$) are in contact with the active regions formed in the substrate (1).

5. A semiconductor integrated circuit device as claimed in any preceding claim, wherein the device is a stacked capacitor-type dynamic random access memory device, and the electrodes ($8_1$, $8_2$) are storage electrodes which are one of paired electrodes of a memory capacitor of the device.

6. A semiconductor integrated circuit device as claimed in any preceding claim, wherein the device is a stacked capacitor-type dynamic random access memory device, and the conductive film (11) is a bit line.

**Patentansprüche**

1. Integrierte Halbleiterschaltung, beinhaltend
ein Halbleitersubstrat (1);
einen Feldisolatorfilm (2), der auf der Oberfläche des Halbleitersubstrats ausgebildet ist und Kanten mit Vogelschnabel-artigen Abschnitten (2a) besitzt;
einen Isolatorfilm (7), der mindestens 2 vierseitige Kontaktlöcher (7a) hat, die auf dem Feldisolatorfilm ausgebildet sind, wobei die Kanten der Kontaktlöcher von Kanten des Feldisolatorfilms (2) oder des Isolatorfilms (7) bestimmt werden; und
Elektroden ($8_1$, $8_2$, 11), die die Kontaktlöcher so abdecken, daß sie in Kontakt mit der Substratoberfläche stehen;
dadurch gekennzeichnet, daß zwei einander gegenüberstehende Kanten eines jeden Kontaktloches, das in einer ersten Richtung (X) geht, von den Vogelschnabel-abschnitten (2a) bestimmt werden, und zwei einander gegenüberstehende Kanten eines jeden Kontaktloches, das in einer zweiten Richtung (Y) verläuft, von den Kanten des Isolatorfilms (7) bestimmt werden;
wobei die Elektrodenführung zwischen benachbarten Elektroden in der zweiten Richtung (Y) sich im wesentlichen bestimmt durch die Formel 2(F + M -B), worin F die kleinstmögliche Musterbreite ist, M die Ausrichtungstoleranz und B die Länge des Vogelschnabels in der zweiten Richtung (Y).

2. Integrierte Halbleiterschaltung nach Anspruch 1, wobei die Elektroden ($8_1$, $8_2$, 11) auf den Kanten des Feldisolatorfilms (2) verlaufen.

3. Integrierte Halbleiterschaltung nach Anspruch 1 oder 2, wobei ein Oberflächenteil des Substrats (1), das durch das Kontaktloch (7a) freiliegt, in der zweiten Richtung (Y) weniger groß ist als das Kontaktloch, das im Isolatorfilm (7) ausgebildet ist.

4. Integrierte Halbleiterschaltung nach Anspruch 1, 2 oder 3, wobei das Substrat aktive Bereiche ($6_1$, $6_2$) aufweist, die mit einer Verunreinigung gedopt sind, und die Elektroden ($8_1$, $8_2$) in Kontakt mit den im Substrat (1) ausgebildeten aktiven Bereichen stehen.

5. Integrierte Halbleiterschaltung nach irgendeinem vorhergehenden Anspruch, wobei die Vorrichtung eine stapelartige Kondensator-ähnliche DRAM-Vorrichtung ist und die Elektroden ($8_1$, $8_2$) Speicherelektroden sind, die eine der gepaarten Elektroden einer Speicherkapazität der Vorrichtung stellen.

6. Integrierte Halbleiterschaltung nach irgendeinem vorhergehenden Anspruch, wobei die Vorrichtung eine stapelartige Kondensator-ähnliche DRAM-Vorrichtung ist und der Leiterfilm (11) eine Bit-Leitung ist.

**Revendications**

1. Circuit intégré semi-conducteur comprenant :
   un substrat semi-conducteur (1);
   une couche isolante épaisse (2) formée sur une surface du substrat semi-conducteur et ayant des bords en forme de parties de bec d'oiseau (2A);
   une couche isolante (7) ayant au moins deux trous de contact à quatre cotés (7A) formée sur la couche isolante épaisse, des bords des trous de contact étant définis par des bords de la couche isolante épaisse (2) ou de la couche isolante (7); et
   des électrodes ($8_1$, $8_2$, 11) recouvrant les trous de contact afin d'être en contact avec la surface du substrat ;
   caractérisé en ce que les deux bords opposés de chaque trou de contact qui s'étendent dans une première direction (X) sont définis par lesdites parties de bec d'oiseau (2A), et les deux bords opposés de chaque trou de contact qui s'étendent dans une seconde direction (Y) sont définis par des bords de la couche isolante (7);
   Ainsi le pas de l'électrode entre des électrodes voisines dans la seconde direction (Y) est substantiellement donné par la formule 2-(F + M-B) dans laquelle F est une largeur de motif minimum, M est une tolérance d'alignement, et B est la longueur du bec d'oiseau dans la seconde direction (Y).

2. Circuit intégré semi-conducteur selon la revendication 1, dans lequel les électrodes ($8_1$, $8_2$, 11) s'étendent sur les bords de la couche isolante épaisse (2).

3. Circuit intégré semi-conducteur selon la revendication 1 ou 2, dans lequel une partie de surface du substrat (1) qui est exposée via le trou de contact (7A) a une dimension dans la seconde direction (Y) plus petite qu'une dimension du trou de contact formé dans la couche isolante (7).

4. Circuit intégré semi-conducteur selon la revendication 1, 2 ou 3, dans lequel le substrat comprend des zones actives ($6_1$, $6_2$) qui sont dopées avec une impureté, et les électrodes ($8_1$, $8_2$) sont en contact avec les zones actives formées dans le substrat (1).

5. Circuit intégré semi-conducteur selon l'une quelconque des revendications précédentes, dans lequel le dispositif est une mémoire dynamique à accès aléatoire du type à condensateur empilé, et les électrodes ($8_1$, $8_2$) sont des électrodes de stockage qui sont l'une des électrodes appairées d'un condensateur mémoire du dispositif.

6. Circuit intégré semi-conducteur selon l'une quelconque des revendications précédentes, dans lequel le dispositif est une mémoire dynamique à accès aléatoire du type à condensateur empilé, et la couche conductrice (11) est une ligne binaire.

FIG.1A

FIG.1B

FIG.1C

# FIG.2 A

# FIG.2 B  (PRIOR ART)

FIG.3

FIG.4

## FIG.5

## FIG.6

## FIG.7

## FIG.8

## FIG.9

## FIG.10

2

2A

p

l

## FIG.11

$6_2$    $6_1$    2    $6_0$

n+    n+    n+

7

p

l

## FIG.12

$6_2$    7A    7A  $6_1$    2    7    $6_0$

n+    n+    n+

p

l

## FIG.13

$6_2$    $8_2$    $6_1$   $8_1$   $2$   $7$    $6_0$

$n+$      $n+$      $n+$

$p$

$I$

## FIG.14

$6_2$   $8_2$   $9$    $6_1$   $8_1$   $2$   $7$    $6_0$

$n+$      $n+$      $n+$

$p$

$I$

## FIG.15

$8_2$   $9_1$   $10$    $8_1$

$12$

$11$

$n+$      $n+$      $n+$

$p$

$I$

$6_2$      $6_1$   $2$   $7$    $6_0$